(19) Europäisches Patentamt
European Patent Office
Office européen des brevets

(11)     EP 3 130 894 B1

(12)     EUROPEAN PATENT SPECIFICATION

(45) Date of publication and mention
of the grant of the patent:
**13.09.2017 Bulletin 2017/37**

(51) Int Cl.:
*G01D 18/00* (2006.01)      *G01D 3/08* (2006.01)

(21) Application number: **16168388.3**

(22) Date of filing: **04.05.2016**

(54) **ABNORMALITY DETECTION DEVICE FOR SENSOR AND SENSOR DEVICE**

ANOMALIEERKENNUNGSVORRICHTUNG FÜR SENSOREN UND SENSORVORRICHTUNG

DISPOSITIF DE DÉTECTION D'ANOMALIE DE CAPTEUR ET DISPOSITIF DE DÉTECTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.05.2015 JP 2015105413**

(43) Date of publication of application:
**15.02.2017 Bulletin 2017/07**

(73) Proprietor: **Alps Electric Co., Ltd.
Tokyo 145-8501 (JP)**

(72) Inventor: **WAKITA, Yoshitsugu
Tokyo, Tokyo 145-8501 (JP)**

(74) Representative: **Schmitt-Nilson Schraud Waibel
Wohlfrom
Patentanwälte Partnerschaft mbB
Destouchesstraße 68
80796 München (DE)**

(56) References cited:
**EP-A2- 1 087 219      EP-A2- 2 157 409
DE-A1- 10 347 038      US-A- 3 976 987
US-A1- 2011 204 877**

**Description**

The present invention relates to an abnormality detection device that detects an abnormality of a detection signal caused by failure or the like, for example, in a sensor that acquires the detection signal from an output of a bridge circuit configured using sensor elements such as magnetic sensors.

For example, there are a variety of sensor elements of which impedance changes according to the physical amount of a detection target, such as a magnetic sensor, a temperature sensor, or a humidity sensor. The sensor elements are often used in the field of detection. In order to obtain a detection signal from such a sensor element with high sensitivity, it is necessary to detect a minute change in the impedance of the sensor element. A bridge circuit has been known as a circuit scheme for such detection.

For example, in the case of a bridge circuit of magnetic sensors used in a rotation angle detection device, sinusoidal signals having a level corresponding to a rotation angle are output from one bridge midpoint and the other bridge midpoint, respectively. Since the two sinusoidal signals are opposite to each other in a phase, a sinusoidal signal having double amplitude is obtained by calculating a difference between the sinusoidal signals.

In such a bridge circuit of the rotation angle detection device, a drift may occur with respect to a center level (offset level) of a fluctuation of the sinusoidal signal according to the rotation angle, for example, due to aging of characteristics, failure, or the like of the magnetic sensors. If the drift occurs, a drift component is included in the difference between the two sinusoidal signals output from the two bridge midpoints of the bridge circuit, in addition to the fluctuation of the sinusoidal signals according to the rotation angle, and exact detection of the rotation angle is not performed.

In a failure detection circuit described in Japanese Unexamined Patent Application Publication No. 2005-49097 below, two sinusoidal signals output from two bridge midpoints of a bridge circuit are added, and an abnormality signal indicating occurrence of a drift is generated in a case in which a signal after addition is out of a predetermined normal range.

However, in the failure detection circuit described in JP 2005-49097 A, buffer units are provided at the two bridge midpoints in order to take out and add the two sinusoidal signals from the two bridge midpoints of the bridge circuit. Since there are two bridge circuits in this failure detection circuit, the total number of buffer units is 4. Accordingly, there is a problem in that a circuit scale increases due to the buffer units being provided. US3976987 describes a line isolation monitor for indicating the maximum hazard current in an ungrounded power distribution system with conductor lines having leakage impedances. The present invention has been made in view of such circumstances, and provides an abnormality detection device for a sensor and a sensor device capable of simplifying a circuit configuration.

An abnormality detection device for a sensor according to a first aspect of the present invention includes a bridge circuit including sensor elements of which the impedance changes according to a change in a physical amount of a detection target, a voltage at a first bridge midpoint and a voltage at a second bridge midpoint exhibiting a change of which the amount of change is equal and the polarity is opposite with respect to a predetermined intermediate voltage according to a change in the impedance of the sensor element; an operational amplifier; a feedback resistor provided between an output terminal and an inverting input terminal of the operational amplifier; a switch circuit that connects the first bridge midpoint to a non-inverting input terminal of the operational amplifier and connects the second bridge midpoint to the inverting input terminal of the operational amplifier in a first connection state, and connects the first bridge midpoint to the inverting input terminal of the operational amplifier and connects the second bridge midpoint to the non-inverting input terminal of the operational amplifier in a second connection state; and a determination unit that determines abnormality of a detection result of the physical amount acquired from an output of the bridge circuit based on a sum of an output signal of the operational amplifier in the first connection state and an output signal of the operational amplifier in the second connection state.

According to the above configuration, since the two bridge midpoints (the first bridge midpoint and the second bridge midpoint) of the bridge circuit and the input terminals (the inverting input terminal and the non-inverting input terminal) of the operational amplifier are connected through the switch circuit, it is possible to omit a buffer circuit for taking out a signal from the two bridge midpoints.

An abnormality detection device for a sensor according to a second aspect of the present invention includes a bridge circuit including sensor elements of which the impedance changes according to a change in a physical amount of a detection target, a voltage at a first bridge midpoint and a voltage at a second bridge midpoint exhibiting a change of which the amount of change is equal and the polarity is opposite with respect to a predetermined intermediate voltage according to a change in the impedance of the sensor element; a first operational amplifier having a non-inverting input terminal connected to the first bridge midpoint and an inverting input terminal connected to the second bridge midpoint; a first feedback resistor provided between an output terminal and the inverting input terminal of the first operational amplifier; a second operational amplifier having a non-inverting input terminal connected to the second bridge midpoint and an inverting input terminal connected to the first bridge midpoint; a second feedback resistor provided between an output terminal and the inverting input terminal of the second operational amplifier; and a determination unit that determines abnormality of a detection result of the physical amount acquired from an output of the bridge circuit based on a sum of an output signal of the first operational amplifier and an output signal of the second operational amplifier.

According to the above configuration, since the two bridge midpoints (the first bridge midpoint and the second bridge midpoint) of the bridge circuit and the input terminals (the inverting input terminal and the non-inverting input terminal) of the first operational amplifier are connected, and the two bridge midpoints and the input terminals (the inverting input terminal and the non-inverting input terminal) of the second operational amplifier are connected, it is possible to omit a buffer circuit for taking out a signal from the two bridge midpoints.

A sensor device according to a third aspect of the present invention includes a bridge circuit including sensor elements of which the impedance changes according to a change in a physical amount of a detection target, a voltage at a first bridge midpoint and a voltage at a second bridge midpoint exhibiting a change of which the amount of change is equal and the polarity is opposite with respect to a predetermined intermediate voltage according to a change in the impedance of the sensor element; an operational amplifier; a feedback resistor provided between an output terminal and an inverting input terminal of the operational amplifier; a switch circuit that connects the first bridge midpoint to the inverting input terminal of the operational amplifier and connects the second bridge midpoint to a non-inverting input terminal of the operational amplifier in a first connection state, and connects the first bridge midpoint to the non-inverting input terminal of the operational amplifier and connects the second bridge midpoint to the inverting input terminal of the operational amplifier in a second connection state; a detection signal acquisition unit that acquires a detection signal indicating a detection result of the physical amount based on a difference between an output signal of the operational amplifier in the first connection state and an output signal of the operational amplifier in the second connection state; and a determination unit that determines abnormality of the detection signal based on a sum of the output signal of the operational amplifier in the first connection state and the output signal of the operational amplifier in the second connection state.

A sensor device according to a fourth aspect of the present invention includes a bridge circuit including sensor elements of which the impedance changes according to a change in a physical amount of a detection target, a voltage at a first bridge midpoint and a voltage at a second bridge midpoint exhibiting a change of which the amount of change is equal and the polarity is opposite with respect to a predetermined intermediate voltage according to a change in the impedance of the sensor element; a first operational amplifier having a non-inverting input terminal connected to the first bridge midpoint and an inverting input terminal connected to the second bridge midpoint; a first feedback resistor provided between an output terminal and the inverting input terminal of the first operational amplifier; a second operational amplifier having a non-inverting input terminal connected to the second bridge midpoint and an inverting input terminal connected to the first bridge midpoint; a second feedback resistor provided between an output terminal and the inverting input terminal of the second operational amplifier; a detection signal acquisition unit that acquires a detection signal indicating a detection result of the physical amount based on a difference between an output signal of the first operational amplifier and an output signal of the second operational amplifier; and a determination unit that determines abnormality of the detection signal based on a sum of the output signal of the first operational amplifier and the output signal of the second operational amplifier.

Preferably, the bridge circuit may include a first sensor element provided between a voltage supply line for supplying a predetermined voltage and the first bridge midpoint; a second sensor element provided between the first bridge midpoint and a reference potential; a third sensor element provided between the voltage supply line and the second bridge midpoint; and a fourth sensor element provided between the second bridge midpoint and the reference potential.

According to the present invention, since it is not necessary to provide a buffer circuit in each bridge midpoint of the bridge circuit, it is possible to simplify a circuit configuration.

GRIEF DESCRIPTION OF THE DRAWINGS

Fig. 1 is a diagram illustrating an example of a configuration of a sensor device according to a first embodiment of the present invention;
Fig. 2 is a diagram illustrating a case in which a switch circuit is in a first connection state;
Fig. 3 is a diagram illustrating a case in which the switch circuit is in a second connection state; and
Fig. 4 is a diagram illustrating an example of a configuration of an abnormality detection device and a sensor device according to a second embodiment of the present invention.

First Embodiment

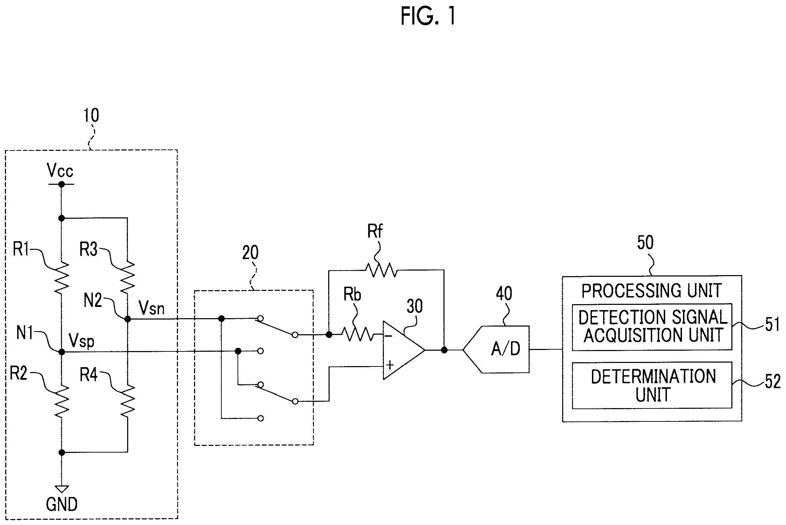

Fig. 1 is a diagram illustrating an example of a configuration of a sensor device according to a first embodiment of the present invention.

The sensor device illustrated in Fig. 1 includes a bridge circuit 10, a switch circuit 20, an operational amplifier 30, a feedback resistor Rf, a resistor Rb, an A/D conversion unit 40, and a processing unit 50. This sensor device operates as an abnormality detection device that detects an abnormality of a detection signal indicating a detection result of a physical amount due to, for example, generation of drift, in addition to an operation of acquiring the detection signal.

The bridge circuit 10 includes sensor elements (R1 to R4) of which the impedance changes according to a change in a physical amount (for example, a magnetic field) of a detection target. In this bridge circuit 10, a voltage at the first bridge midpoint and a voltage at the second bridge midpoint exhibit a change of which the amount of change is equal and the polarity is opposite with respect to a predetermined intermediate voltage Vofs according to a change in the impedance of the sensor elements (R1 to R4). If a voltage at a first bridge midpoint N1 is "Vsp" and a voltage at a second bridge midpoints N2 is "Vsn", the voltages Vsp and Vsn are expressed by the following equations, respectively.

$$Vsp = A \cdot sin\theta + Vofs \ ... \ (1)$$

$$Vsn = -A \cdot sin\theta + Vofs \ ... \ (2)$$

In Equations (1) and (2), "A" indicates a constant coefficient, and "$sin\theta$" indicates a variable with a value from -1 to 1. A value of "$sin\theta$" changes according to the detection result of the physical amount of the sensor elements (R1 to R4). For example, in the case of a rotation angle sensor that detects a magnetic field of a magnet provided in a rotation body using the sensor elements (R1 to R4), the magnet and the sensor elements (R1 to R4) are arranged such that the voltages Vsp and Vsn show changes shown in Equations (1) and (2) according to an angle $\theta$ of rotation.

Relationships of Equations (1) and (2) are satisfied in a case in which each of the first bridge midpoint N1 and the second bridge midpoint N2 is not connected to the operational amplifier 30. In a case in which the first bridge midpoint N1 and the second bridge midpoint N2 are connected to the operational amplifier 30 through the switch circuit 20 to be described below, the voltages Vsp and Vsn are substantially equal voltages.

The bridge circuit 10 illustrated in the example of Fig. 1 includes a first sensor element R1, a second sensor element R2, a third sensor element R3, and a fourth sensor element R4. The first sensor element R1 is provided between a voltage supply line for supplying a power supply voltage Vcc and the first bridge midpoint N1. The second sensor element R2 is provided between the first bridge midpoint N1 and a reference potential GND. The third sensor element R3 is provided between the voltage supply line for the power supply voltage Vcc and the second bridge midpoint N2. The fourth sensor element R4 is provided between the second bridge midpoint N2 and the reference potential GND.

In a normal state, the amounts of change in the impedance of the sensor elements (R1 to R4) according to the change in the physical amount of the detection target are substantially equal. Polarities of the change in the impedance according to the change in the physical amount of the detection target are opposite in the first sensor element R1 and the second sensor element R2, opposite in the third sensor element R3 and the fourth sensor element R4, the same in the first sensor element R1 and the fourth sensor element R4, and the same in the second sensor element R2 and the third sensor element R3.

In a case in which the impedance of the first sensor element R1 and the impedance of the second sensor element R2 are equal, the impedance of the third sensor element R3 and the impedance of the fourth sensor element R4 are also equal. In this case, from the relationships of Equations (1) and (2), the voltages Vsp and Vsn become both equal to the intermediate voltage Vofs. Accordingly, the intermediate voltage Vofs becomes equal to a half voltage (Vcc/2) of the power supply voltage Vcc.

The switch circuit 20 is a circuit for switching a connection between the two bridge midpoints (N1 and N2) of the bridge circuit 10 and two input terminals (an inverting input terminal and a non-inverting input terminal) of the operational amplifier 30, and having a first connection state and a second connection state.

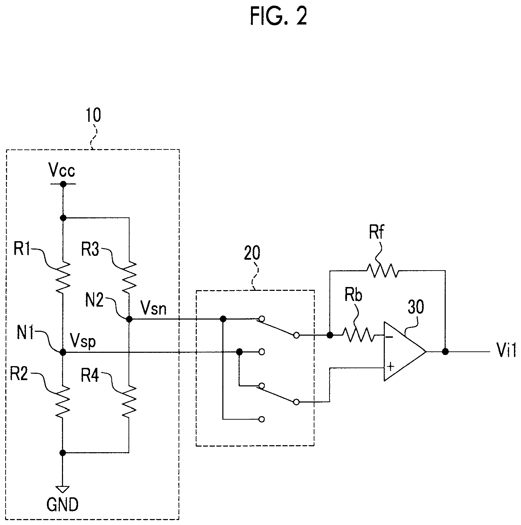

In the first connection state, the switch circuit 20 connects the first bridge midpoint N1 to the non-inverting input terminal of the operational amplifier 30 and connects the second bridge midpoint N2 to the inverting input terminal of the operational amplifier 30 (Fig. 2).

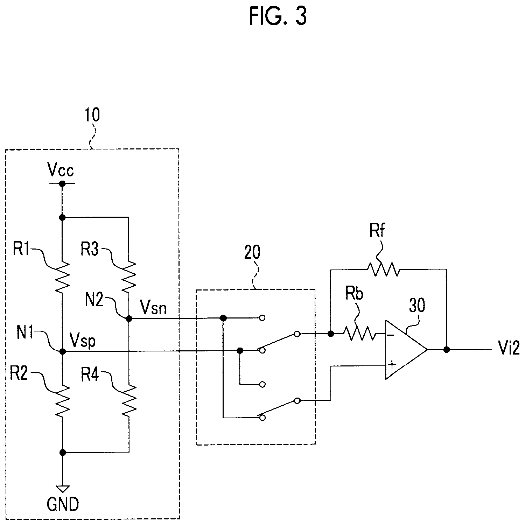

In the second connection state, the switch circuit 20 connects the first bridge midpoint N1 to the inverting input terminal of the operational amplifier 30 and connects the second bridge midpoint N2 to the non-inverting input terminal of the operational amplifier 30 (Fig. 3).

The feedback resistor Rf is connected between an output terminal of the operational amplifier 30 and the inverting input terminal.

The resistor Rb is provided in a path of a current flowing between a node to which the switch circuit 20 and one terminal of the feedback resistor Rf are connected and the inverting input terminal of the operational amplifier 30. This resistor Rb is intended to reduce an offset voltage of the operational amplifier 30 which is generated due to an influence of a minute input current flowing in the inverting input terminal and the non-inverting input terminal of the operational amplifier 30. A resistance value of the resistor Rb is set such that impedance of a circuit connected to the inverting input terminal of the operational amplifier 30 and impedance of a circuit connected to the non-inverting input terminal of the operational amplifier 30 are approximate to each other.

The A/D conversion unit 40 converts an output signal of the operational amplifier 30 from an analog signal to a digital signal.

The processing unit 50 is a circuit that generally controls an entire operation of the sensor device. For example, the processing unit 50 controls a switching operation of the switch circuit 20 and a conversion operation of the A/D conversion unit 40 so that respective output signals in a first connection state (Fig. 2) and a second connection state (Fig. 3) of the operational amplifier 30 are obtained in a case in which a predetermined command is given from a high-level device (not illustrated) or at a periodic timing set in advance.

For example, the processing unit 50 includes a computer that executes processing according to an instruction code of a program stored in a memory, or a logic circuit (for example, ASIC) according to dedicated hardware. Entire processing of the processing unit 50 may be executed by the computer or at least a part of the processing may be executed by the logic circuit of hardware.

The processing unit 50 is a block that processes the output signal of the operational amplifier 30 converted Into the digital signal by the A/D conversion unit 40, and includes a detection signal acquisition unit 51 and a determination unit 52.

The detection signal acquisition unit 51 acquires a detection signal indicating a detection result of the physical amount based on a difference between the output signal of the operational amplifier 30 in the first connection state (Fig. 2) and the output signal of the operational amplifier 30 in the second connection state (Fig. 3).

The determination unit 52 determines an abnormality of the detection signal acquired by the detection signal acquisition unit 51 based on a sum of the output signal of the operational amplifier 30 in the first connection state (Fig. 2) and the output signal of the operational amplifier 30 in the second connection state (Fig. 3).

Here, an operation of the sensor device illustrated in Fig. 1 having the above-described configuration at the time of normality and abnormality will be described.

(At the time of normality)

If the output signal of the operational amplifier 30 in in the first connection state (Fig. 2) is "Vi1" and the output signal of the operational amplifier 30 in the second connection state (Fig. 3) is "Vi2", the output signals Vi1 and Vi2 are respectively expressed by the following equations.

$$Vi1 = G1 \cdot (Vsp - Vsn) + Vsp \quad \dots \quad (3)$$

$$Vi2 = G2 \cdot (Vsn - Vsp) + Vsn \quad \dots \quad (4)$$

"G1" in Equation (3) indicates a voltage gain determined by the respective resistance values of the sensor elements R1 and R2 of the bridge circuit 10 and the feedback resistor Rf. Further, "G2" in Equation (4) indicates a voltage gain determined by the respective resistance values of the sensor elements R3 and R4 of the bridge circuit 10 and the feedback resistor Rf. If the resistance values of the sensor elements R1, R2, R3, and R4 are "R1", "R2", "R3", and "R4", respectively, and the resistance value of the feedback resistor Rf is "Rf", the voltage gains G1 and G2 are expressed by the following equations, respectively.

$$G1 = Rf \cdot (R1 + R2) / (R1 \cdot R2) \quad \dots \quad (5)$$

$$G2 = Rf \cdot (R3 + R4) / (R3 \cdot R4) \quad \dots \quad (6)$$

Here, if relationships $(R1 + R2) \approx (R3 + R4)$ and $(R1 \cdot R2) \approx (R3 \cdot R4)$ are satisfied, the voltage gains G1 and G2 become approximately equal. When this voltage gain is "G", Equations (3) and (4) are expressed by the following equations.

$$Vi1 = G \cdot (Vsp-Vsn)+Vsp \quad ... \quad (7)$$

$$Vi2 = G \cdot (Vsn-Vsp)+Vsn \quad ... \quad (8)$$

From Equations (1), (2), (7), and (8), the output signals Vi1 and Vi2 are respectively expressed by the following equations.

$$Vi1 = (1+2G) \cdot A \cdot \sin\theta + Vofs \quad ... \quad (9)$$

$$Vi2 = -(1+2G) \cdot A \cdot \sin\theta + Vofs \quad ... \quad (10)$$

The result of subtracting the output signal Vi2 from the output signal Vi1 is expressed as the following equation using Equations (9) and (10).

$$Vi1-Vi2 = (1+2G) \cdot 2A \cdot \sin\theta \quad ... \quad (11)$$

As seen from Equation (11), in a case in which a detection operation is normally performed, a signal of a result of subtracting the output signal Vi2 from the output signal Vi1 is a signal which is in proportional to a change "$\sin\theta$" in a physical amount detected in the sensor elements (R1 to R4). The detection signal acquisition unit 51 acquires the signal of the subtraction result shown in Equation (11) as a detection signal.
On the other hand, a result of adding the output signal Vi1 and the output signal Vi2 is expressed as shown in the following equation using Equations (9) and (10).

$$Vi1+Vi2 = 2 \cdot Vofs = Vcc \quad ... \quad (12)$$

As seen from Equation (12), in a case in which the detection operation is normally performed, a result of adding the output signal Vi1 and the output signal Vi2 becomes substantially a constant value. The determination unit 52 determines whether or not the result of adding the output signal Vi1 and the output signal Vi2 is included in a predetermined normal range having the power supply voltage Vcc as a center value, and determines that the detection signal acquired by the detection signal acquisition unit 51 is normal in a case in which the addition result is included in the normal range.

(At the time of abnormality)

If a drift voltage $\Delta$ occurs in the voltage Vsp at the first bridge midpoint N1, Equation (1) of the voltage Vsp is changed as shown in Equation (1A) below.

$$Vsp = Vofs+A \cdot \sin\theta+\Delta \quad ... \quad (1A)$$

From Equations (1A), (2), (7), and (8), output signals Vi1A and Vi2A at the time of abnormality are expressed by the following equations.

$$Vi1A = (1+2G) \cdot A \cdot \sin\theta + Vofs+(1+G) \cdot \Delta \quad ... \quad (9A)$$

$$Vi2A = -(1+2G) \cdot A \cdot \sin\theta + Vofs-G \cdot \Delta \quad ... \quad (10A)$$

A result of subtracting the output signal Vi2A from the output signal Vi1A is expressed as shown in the following equation using Equations (9A) and (10A).

$$Vi1A-Vi2A = (1+2G) \cdot (2A \cdot \sin\theta+\Delta) \quad \dots \quad (11A)$$

As shown in Equation (11A), an error component derived from the drift voltage $\Delta$ is included in the detection signal acquired in the detection signal acquisition unit 51. Therefore, the detection signal does not correctly represent a change "$\sin\theta$" in the physical amount detected in the sensor elements (R1 to R4).

A result of adding the output signal Vi1A and the output signal Vi2A is expressed as shown in the following equation using Equations (9A) and (10A).

$$Vi1A+Vi2A = 2 \cdot Vofs+\Delta = Vcc+\Delta \quad \dots \quad (12A)$$

In a case in which the drift voltage $\Delta$ is included in the output signal Vi1A the result of adding the output signal Vi1 and the output signal Vi2 becomes a voltage separated from the supply voltage Vcc by the drift voltage $\Delta$, as compared with the time of normality (Equation (12)). Therefore, if the drift voltage $\Delta$ increases beyond a certain limit, the result of adding the output signal Vi1 and the output signal Vi2 deviates from a predetermined normal range in which the power supply voltage Vcc is a center value, and the determination unit 52 determines that the detection signal acquired by the detection signal acquisition unit 51 is abnormal.

As described above, according to the sensor device according to this embodiment, the two input terminals (the inverting input terminal and the non-inverting input terminal) of the operational amplifier 30 in which the output voltage is fed back to the inverting input terminal via the feedback resistor Rf, and the two bridge midpoints (N1 and N2) of the bridge circuit 10 are connected via the switch circuit 20. The detection signal indicating the detection result of the physical amount of the sensor elements (R1 to R4) is acquired based on the difference between the output signal Vi1 of the operational amplifier 30 in a case in which the switch circuit 20 is in the first connection state (Fig. 2) and the output signal Vi2 of the operational amplifier 30 in a case in which the switch circuit 20 is in the second connection state (Fig. 3), and the abnormality of the detection signal is determined based on the sum of the output signal Vi1 and the output signal Vi2.

Accordingly, since the buffer circuit for taking out the signal from the two bridge midpoints (N1 and N2) of the bridge circuit 10 can be omitted, it is possible to simplify the circuit configuration.

Second embodiment

Next, a second embodiment of the present invention will be described.

The sensor device according to the first embodiment described above generates the output signals (Vi1 and Vi2) of two patterns by switching the connection between one operational amplifier 30, in which the output voltage is fed back to the inverting input terminal via the feedback resistor Rf, and the bridge circuit 10 using the switch circuit 20. On the other hand, the sensor device according to the second embodiment generates the same output signal of two patterns as that in the first embodiment, using two operational amplifiers.

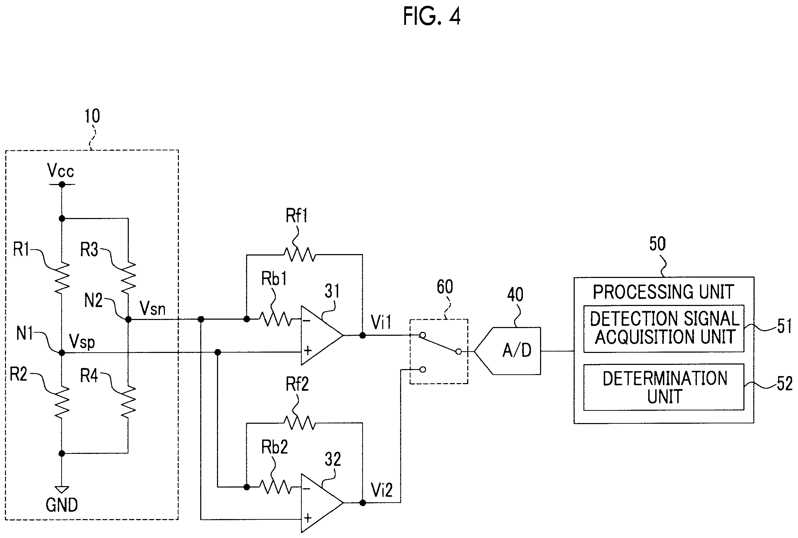

Fig. 4 is a diagram illustrating an example of a configuration of a sensor device according to the second embodiment.

The sensor device illustrated in Fig. 4 includes a bridge circuit 10, a first operational amplifier 31 and a second operational amplifier 32, a first feedback resistor Rf1 and a second feedback resistor Rf2, resistors Rb1 and Rb2, a switch circuit 60, an A/D conversion unit 40, and a processing unit 50. In these components, since the bridge circuit 10, the A/D conversion unit 40, and the processing unit 50 are the same as those in the sensor device illustrated in Fig. 1, other components will be described hereinafter.

In the first operational amplifier 31, a non-inverting input terminal is connected to a first bridge midpoint N1, and an inverting input terminal is connected to a second bridge midpoint N2.

In the second operational amplifier 32, a non-inverting input terminal is connected to the second bridge midpoint N2, and an inverting input terminal is connected to the first bridge midpoint N1.

The first feedback resistor Rf1 is provided between an output terminal and the inverting input terminal of the first operational amplifier 31. The second feedback resistor Rf2 is provided between an output terminal and the inverting input terminal of the second operational amplifier 32. The first feedback resistor Rf1 and the second feedback resistor Rf2 have a substantially equal resistance value. The first feedback resistor Rf1 and the second feedback resistor Rf2 have a resistance value sufficiently greater than those of resistors (R1 to R4) of the bridge circuit 10.

The resistor Rb1 is provided in a path of a current flowing between a node to which the second bridge midpoint N2 and one terminal of the feedback resistor Rf1 are connected and the inverting input terminal of the first operational amplifier 31. The resistor Rb2 is provided in a path of a current flowing between a node to which the first bridge midpoint N1 and one terminal of the feedback resistor Rf2 are connected and the inverting input terminal of the second operational amplifier 32. Functions of the resistors Rb1 and Rb2 are the same as that of the resistor Rb in Fig. 1.

The switch circuit 60 selects one of an output signal Vi1 of the first operational amplifier 31 and an output signal Vi2 of the second operational amplifier 32 and inputs the output signal to the A/D conversion unit 40.

In the sensor device illustrated in Fig. 4, the output signal Vi1 of the first operational amplifier 31 and the output signal Vi2 of the second operational amplifier 32 are input to the A/D conversion unit 40 via the switch circuit 60, are respectively converted into digital signals, and then, are input to a detection signal acquisition unit 51 and a determination unit 52 of the processing unit 50. In the detection signal acquisition unit 51, a detection signal is acquired based on a difference between the output signal Vi1 and the output signal Vi2. In the determination unit 52, abnormality of the detection signal is determined based on a sum of the output signal Vi1 and the output signal Vi2.

In the sensor device illustrated in Fig. 4, since the buffer circuit for taking out the signals from the two bridge midpoints (N1 and N2) of the bridge circuit 10 can be omitted, it is possible to simplify a circuit configuration, as in the sensor device illustrated in Fig. 1.

The present invention is not limited to the above-described embodiments. That is, a person skilled in the art may perform various modifications, combinations, sub-combinations, and alternations on the components of the above-described embodiments within the technical scope of the claims.

Although the example in which the bridge circuit 10 includes four sensor elements (R1 to R4) has been described in the above-described embodiments, some of the four sensor elements (R1 to R4) may be replaced with resistors having fixed resistance in other embodiments of the present invention.

Although the output signals of the two operational amplifiers (31 and 32) are converted into the digital signals by one A/D conversion unit 40 in the sensor device illustrated in Fig. 4, A/D conversion units may be provided in the outputs of the two operational amplifiers (31 and 32), respectively, in other embodiments of the present invention.

Although the signal processing of the detection signal acquisition unit 51 and the determination unit 52 is performed by a digital circuit in the above-described embodiments, the signal processing may be performed by an analog circuit in other embodiments of the present invention.

It should be understood by those skilled in the art that various modifications, combinations, sub-combinations and alternations may occur depending on design requirements and other factors insofar as they are within the scope of the appended claims.

## Claims

1.   An abnormality detection device for a sensor, comprising:

 a bridge circuit (10) including sensor elements of which the impedance changes according to a change in a physical amount of a detection target, a voltage at a first bridge midpoint (N1) and a voltage at a second bridge midpoint (N2) exhibiting a change of which the amount of change is equal and the polarity is opposite with respect to a predetermined intermediate voltage according to a change in the impedance of the sensor element;
 an operational amplifier (30);
 a feedback resistor (Rf) provided between an output terminal and an inverting input terminal of the operational amplifier (30);
 a switch circuit (20) that connects the first bridge midpoint (N1) to a non-inverting input terminal of the operational amplifier (30) and connects the second bridge midpoint (N2) to the inverting input terminal of the operational amplifier (30) in a first connection state, and connects the first bridge midpoint (N1) to the inverting input terminal of the operational amplifier (30) and connects the second bridge midpoint (N2) to the non-inverting input terminal of the operational amplifier (30) in a second connection state; and
 a determination unit (52) that determines abnormality of a detection result of the physical amount acquired from an output of the bridge circuit (10) based on a sum of an output signal of the operational amplifier (30) in the first connection state and an output signal of the operational amplifier (30) in the second connection state.

2.   An abnormality detection device for a sensor, comprising:

 a bridge circuit (10) including sensor elements of which the impedance changes according to a change in a physical amount of a detection target, a voltage at a first bridge midpoint (N1) and a voltage at a second bridge midpoint (N2) exhibiting_a change of which the amount of change is equal and the polarity is opposite with respect to a predetermined intermediate voltage according to a change in the impedance of the sensor element;
 a first operational amplifier (31) having a non-inverting input terminal connected to the first bridge midpoint (N1) and an inverting input terminal connected to the second bridge midpoint (N2);

a first feedback resistor (Rf1) provided between an output terminal and the inverting input terminal of the first operational amplifier (31);

a second operational amplifier (32) having a non-inverting input terminal connected to the second bridge midpoint (N2) and an inverting input terminal connected to the first bridge midpoint (N1);

a second feedback resistor (Rf2) provided between an output terminal and the inverting input terminal of the second operational amplifier (32); and

a determination unit (52) that determines abnormality of a detection result of the physical amount acquired from an output of the bridge circuit (10) based on a sum of an output signal of the first operational amplifier (31) and an output signal of the second operational amplifier (32).

3.  A sensor device, comprising:

a bridge circuit (10) including sensor elements of which the impedance changes according to a change in a physical amount of a detection target, a voltage at a first bridge midpoint (N1) and a voltage at a second bridge midpoint (N2) exhibiting a change of which the amount of change is equal and the polarity is opposite with respect to a predetermined intermediate voltage according to a change in the impedance of the sensor element;

an operational amplifier (30);

a feedback resistor (Rf) provided between an output terminal and an inverting input terminal of the operational amplifier (30);

a switch circuit (20) that connects the first bridge midpoint to the inverting input terminal of the operational amplifier (30) and connects the second bridge midpoint (N2) to a non-inverting input terminal of the operational amplifier (30) in a first connection state, and connects the first bridge midpoint (N1) to the non-inverting input terminal of the operational amplifier (30) and connects the second bridge midpoint (N2) to the inverting input terminal of the operational amplifier (30) in a second connection state;

a detection signal acquisition unit (51) that acquires a detection signal indicating a detection result of the physical amount based on a difference between an output signal of the operational amplifier (30) in the first connection state and an output signal of the operational amplifier (30) in the second connection state; and

a determination unit (52) that determines abnormality of the detection signal based on a sum of the output signal of the operational amplifier (30) in the first connection state and the output signal of the operational amplifier (30) in the second connection state.

4.  A sensor device, comprising:

a bridge circuit (10) including sensor elements of which the impedance changes according to a change in a physical amount of a detection target, a voltage at a first bridge midpoint (N1) and a voltage at a second bridge midpoint (N2) exhibiting a change of which the amount of change is equal and the polarity is opposite with respect to a predetermined intermediate voltage according to a change in the impedance of the sensor element;

a first operational amplifier (31) having a non-inverting input terminal connected to the first bridge midpoint (N1) and an inverting input terminal connected to the second bridge midpoint (N2);

a first feedback resistor (Rf1) provided between an output terminal and the inverting input terminal of the first operational amplifier (31);

a second operational amplifier (32) having a non-inverting input terminal connected to the second bridge midpoints (N2) and an inverting input terminal connected to the first bridge midpoint (N1);

a second feedback resistor (Rf2) provided between an output terminal and the inverting input terminal of the second operational amplifier (32);

a detection signal acquisition unit (51) that acquires a detection signal indicating a detection result of the physical amount based on a difference between an output signal of the first operational amplifier (31) and an output signal of the second operational amplifier (32); and

a determination unit (52) that determines abnormality of the detection signal based on a sum of the output signal of the first operational amplifier (31) and the output signal of the second operational amplifier (32).

5.  The sensor device according to any one of claims 1 to 4,

wherein the bridge circuit (10) includes

a first sensor element (R1) provided between a voltage supply line for supplying a predetermined voltage and the first bridge midpoint (N1);

a second sensor element (R2) provided between the first bridge midpoint (N1) and a reference potential;

a third sensor element (R3) provided between the voltage supply line and the second bridge midpoint (N2); and

a fourth sensor element (R4) provided between the second bridge midpoint (N2) and the reference potential.

**Patentansprüche**

1. Anomalieerkennungsvorrichtung für einen Sensor mit:

   einer Brückenschaltung (10), die Sensorelemente aufweist, deren Impedanz sich entsprechend einer Änderung einer physikalischen Menge eines Erkennungsziels ändert, wobei eine Spannung an einem ersten Brückenmittelpunkt (N1) und eine Spannung an einem zweiten Brückenmittelpunkt (N2) eine Änderung, deren Änderungsausmaß gleich ist und Polarität bezüglich einer vorbestimmten Zwischenspannung entgegengesetzt ist, entsprechend einer Änderung der Impedanz des Sensorelements aufweisen;
   einem Operationsverstärker (30);
   einem Rückkopplungswiderstand (Rf), der zwischen einem Ausgangsanschluss und einem invertierenden Eingangsanschluss des Operationsverstärkers (30) vorgesehen ist;
   einer Schaltschaltung (20), die in einem ersten Verbindungszustand den ersten Brückenmittelpunkt (N1) mit einem nicht invertierenden Eingangsanschluss des Operationsverstärkers (30) verbindet und den zweiten Brückenmittelpunkt (N2) mit dem invertierenden Eingangsanschluss des Operationsverstärkers (30) verbindet und in einem zweiten Verbindungszustand den ersten Brückenmittelpunkt (N1) mit dem invertierenden Eingangsanschluss des Operationsverstärkers (30) verbindet und den zweiten Brückenmittelpunkt (N2) mit dem nicht invertierenden Eingangsanschluss des Operationsverstärkers (30) verbindet; und
   einer Bestimmungseinheit (52), die eine Anomalie eines Erkennungsergebnisses der physikalischen Menge, das aus einer Ausgabe der Brückenschaltung (10) bezogen wird, auf Grundlage einer Summe eines Ausgangssignals des Operationsverstärkers (30) in dem ersten Verbindungszustand und eines Ausgangssignals des Operationsverstärkers (30) in dem zweiten Verbindungszustand bestimmt.

2. Anomalieerkennungsvorrichtung für einen Sensor mit:

   einer Brückenschaltung (10), die Sensorelemente aufweist, deren Impedanz sich entsprechend einer Änderung einer physikalischen Menge eines Erkennungsziels ändert, wobei eine Spannung an einem ersten Brückenmittelpunkt (N1) und eine Spannung an einem zweiten Brückenmittelpunkt (N2) eine Änderung, deren Änderungsausmaß gleich ist und Polarität bezüglich einer vorbestimmten Zwischenspannung entgegengesetzt ist, entsprechend einer Änderung der Impedanz des Sensorelements aufweisen;
   einem ersten Operationsverstärker (31) mit einem nicht invertierenden Eingangsanschluss, der mit dem ersten Brückenmittelpunkt (N1) verbunden ist, und einem invertierenden Eingangsanschluss, der mit dem zweiten Brückenmittelpunkt (N2) verbunden ist;
   einem ersten Rückkopplungswiderstand (Rf1), der zwischen einem Ausgangsanschluss und dem invertierenden Eingangsanschluss des ersten Operationsverstärkers (31) vorgesehen ist;
   einem zweiten Operationsverstärker (32) mit einem nicht invertierenden Eingangsanschluss, der mit dem zweiten Brückenmittelpunkt (N2) verbunden ist, und einem invertierenden Eingangsanschluss, der mit dem ersten Brückenmittelpunkt (N1) verbunden ist;
   einem zweiten Rückkopplungswiderstand (Rf2), der zwischen einem Ausgangsanschluss und dem invertierenden Eingangsanschluss des zweiten Operationsverstärkers (32) vorgesehen ist; und
   einer Bestimmungseinheit (52), die eine Anomalie eines Erkennungsergebnisses der physikalischen Menge, das aus einer Ausgabe der Brückenschaltung (10) bezogen wird, auf Grundlage einer Summe eines Ausgangssignals des ersten Operationsverstärkers (31) und eines Ausgangssignals des zweiten Operationsverstärkers (32) bestimmt.

3. Sensorvorrichtung mit:

   einer Brückenschaltung (10), die Sensorelemente aufweist, deren Impedanz sich entsprechend einer Änderung einer physikalischen Menge eines Erkennungsziels ändert, wobei eine Spannung an einem ersten Brückenmittelpunkt (N1) und eine Spannung an einem zweiten Brückenmittelpunkt (N2) eine Änderung, deren Änderungsausmaß gleich ist und Polarität bezüglich einer vorbestimmten Zwischenspannung entgegengesetzt ist, entsprechend einer Änderung der Impedanz des Sensorelements aufweisen;
   einem Operationsverstärker (30);
   einem Rückkopplungswiderstand (Rf), der zwischen einem Ausgangsanschluss und einem invertierenden Eingangsanschluss des Operationsverstärkers (30) vorgesehen ist;

einer Schaltschaltung (20), die in einem ersten Verbindungszustand den ersten Brückenmittelpunkt mit dem invertierenden Eingangsanschluss des Operationsverstärkers (30) verbindet und den zweiten Brückenmittelpunkt (N2) mit einem nicht invertierenden Eingangsanschluss des Operationsverstärkers (30) verbindet und in einem zweiten Verbindungszustand den ersten Brückenmittelpunkt (N1) mit dem nicht invertierenden Eingangsanschluss des Operationsverstärkers (30) verbindet und den zweiten Brückenmittelpunkt (N2) mit dem invertierenden Eingangsanschluss des Operationsverstärkers (30) verbindet;

einer Erkennungssignalbezugseinheit (51), die ein Erkennungssignal bezieht, das ein Erkennungsergebnis der physikalischen Menge auf Grundlage einer Differenz zwischen einem Ausgangssignal des Operationsverstärkers (30) in dem ersten Verbindungszustand und einem Ausgangssignal des Operationsverstärkers (30) in dem zweiten Verbindungszustand angibt; und

einer Bestimmungseinheit (52), die eine Anomalie des Erkennungssignals auf Grundlage einer Summe des Ausgangssignals des Operationsverstärkers (30) in dem ersten Verbindungszustand und des Ausgangssignals des Operationsverstärkers (30) in dem zweiten Verbindungszustand bestimmt.

4. Sensorvorrichtung mit:

einer Brückenschaltung (10), die Sensorelemente aufweist, deren Impedanz sich entsprechend einer Änderung einer physikalischen Menge eines Erkennungsziels ändert, wobei eine Spannung an einem ersten Brückenmittelpunkt (N1) und eine Spannung an einem zweiten Brückenmittelpunkt (N2) eine Änderung, deren Änderungsausmaß gleich ist und Polarität bezüglich einer vorbestimmten Zwischenspannung entgegengesetzt ist, entsprechend einer Änderung der Impedanz des Sensorelements aufweisen;

einem ersten Operationsverstärker (31) mit einem nicht invertierenden Eingangsanschluss, der mit dem ersten Brückenmittelpunkt (N1) verbunden ist, und einem invertierenden Eingangsanschluss, der mit dem zweiten Brückenmittelpunkt (N2) verbunden ist;

einem ersten Rückkopplungswiderstand (Rf1), der zwischen einem Ausgangsanschluss und dem invertierenden Eingangsanschluss des ersten Operationsverstärkers (31) vorgesehen ist;

einem zweiten Operationsverstärker (32) mit einem nicht invertierenden Eingangsanschluss, der mit dem zweiten Brückenmittelpunkt (N2) verbunden ist, und einem invertierenden Eingangsanschluss, der mit dem ersten Brückenmittelpunkt (N1) verbunden ist;

einem zweiten Rückkopplungswiderstand (Rf2), der zwischen einem Ausgangsanschluss und dem invertierenden Eingangsanschluss des zweiten Operationsverstärkers (32) vorgesehen ist;

einer Erkennungssignalbezugseinheit (51), die ein Erkennungssignal bezieht, das ein Erkennungsergebnis der physikalischen Menge auf Grundlage einer Differenz zwischen einem Ausgangssignal des ersten Operationsverstärkers (31) und einem Ausgangssignal des zweiten Operationsverstärkers (32) angibt; und

einer Bestimmungseinheit (52), die eine Anomalie des Erkennungssignals auf Grundlage einer Summe des Ausgangssignals des ersten Operationsverstärkers (31) und des Ausgangssignals des zweiten Operationsverstärkers (32) bestimmt.

5. Sensorvorrichtung nach einem der Ansprüche 1 bis 4,

wobei die Brückenschaltung (1) umfasst
ein erstes Sensorelement (R1), das zwischen einer Spannungszufuhrleitung für das Zuführen einer vorbestimmten Spannung und dem ersten Brückenmittelpunkt (N1) vorgesehen ist;
ein zweites Sensorelement (R2), das zwischen dem ersten Brückenmittelpunkt (N1) und einem Bezugspotenzial vorgesehen ist;
ein drittes Sensorelement (R3), das zwischen der Spannungszufuhrleitung und dem zweiten Brückenmittelpunkt (N2) vorgesehen ist;
ein viertes Sensorelement (R4), das zwischen dem zweiten Brückenmittelpunkt (N2) und dem Bezugspotenzial vorgesehen ist.

**Revendications**

1. Dispositif de détection d'anomalie pour capteur, comprenant :

un circuit en pont (10) comprenant des éléments capteurs dont l'impédance varie en fonction des variations d'une grandeur physique d'une cible de détection, une tension en un premier point milieu de pont (N1) et une tension en un second point milieu de pont (N2) présentant des variations, dont la quantité de variation est égale et la polarité est opposée, par rapport à une tension intermédiaire prédéterminée, en fonction des variations de l'impédance de l'élément capteur ;

un amplificateur opérationnel (30) ;

une résistance de rétroaction (Rf) disposée entre une borne de sortie et une borne d'entrée inverseuse de l'amplificateur opérationnel (30) ;

un circuit de commutation (20) qui connecte le premier point milieu de pont (N1) à une borne d'entrée non inverseuse de l'amplificateur opérationnel (30) et connecte le second point milieu de pont (N2) à la borne d'entrée inverseuse de l'amplificateur opérationnel (30) dans un premier état de connexion, et connecte le premier point milieu de pont (N1) à la borne d'entrée inverseuse de l'amplificateur opérationnel (30) et connecte le second point milieu de pont (N2) à la borne d'entrée non inverseuse de l'amplificateur opérationnel (30) dans un second état de connexion ; et

une unité de détermination (52) qui détermine une anomalie du résultat de détection de la grandeur physique acquis à partir d'une sortie du circuit en pont (10) sur la base d'une somme d'un signal de sortie de l'amplificateur opérationnel (30) dans le premier état de connexion et d'un signal de sortie de l'amplificateur opérationnel (30) dans le second état de connexion.

2. Dispositif de détection d'anomalie pour capteur, comprenant :

un circuit en pont (10) comprenant des éléments capteurs dont l'impédance varie en fonction des variations d'une grandeur physique d'une cible de détection, une tension en un premier point milieu de pont (N1) et une tension en un second point milieu de pont (N2) présentant des variations, dont la quantité de variation est égale et la polarité est opposée, par rapport à une tension intermédiaire prédéterminée, en fonction des variations de l'impédance de l'élément capteur ;

un premier amplificateur opérationnel (31) comportant une borne d'entrée non inverseuse connectée au premier point milieu de pont (N1) et une borne d'entrée inverseuse connectée au second point milieu de pont (N2) ;

une première résistance de rétroaction (Rf1) disposée entre une borne de sortie et la borne d'entrée inverseuse du premier amplificateur opérationnel (31) ;

un second amplificateur opérationnel (32) comportant une borne d'entrée non inverseuse connectée au second point milieu de pont (N2) et une borne d'entrée inverseuse connectée au premier point milieu de pont (N1) ;

une seconde résistance de rétroaction (Rf2) disposée entre une borne de sortie et la borne d'entrée inverseuse du second amplificateur opérationnel (32) ; et

une unité de détermination (52) qui détermine une anomalie du résultat de détection de la grandeur physique acquis à partir d'une sortie du circuit en pont (10) sur la base d'une somme d'un signal de sortie du premier amplificateur opérationnel (31) et d'un signal de sortie du second amplificateur opérationnel (32).

3. Dispositif capteur, comprenant :

un circuit en pont (10) comprenant des éléments capteurs dont l'impédance varie en fonction des variations d'une grandeur physique d'une cible de détection, une tension en un premier point milieu de pont (N1) et une tension en un second point milieu de pont (N2) présentant des variations, dont la quantité de variation est égale et la polarité est opposée, par rapport à une tension intermédiaire prédéterminée, en fonction des variations de l'impédance de l'élément capteur ;

un amplificateur opérationnel (30) ;

une résistance de rétroaction (Rf) disposée entre une borne de sortie et une borne d'entrée inverseuse de l'amplificateur opérationnel (30) ;

un circuit de commutation (20) qui connecte le premier point milieu de pont (N1) à la borne d'entrée inverseuse de l'amplificateur opérationnel (30) et connecte le second point milieu de pont (N2) à une borne d'entrée non inverseuse de l'amplificateur opérationnel (30) dans un premier état de connexion, et connecte le premier point milieu de pont (N1) à la borne d'entrée non inverseuse de l'amplificateur opérationnel (30) et connecte le second point milieu de pont (N2) à la borne d'entrée inverseuse de l'amplificateur opérationnel (30) dans un second état de connexion ;

une unité d'acquisition de signal de détection (51) qui acquiert un signal de détection indiquant un résultat de détection de la grandeur physique sur la base d'une différence entre un signal de sortie de l'amplificateur opérationnel (30) dans le premier état de connexion et un signal de sortie de l'amplificateur opérationnel (30) dans le second état de connexion ; et

une unité de détermination (52) qui détermine une anomalie du signal de détection sur la base d'une somme du signal de sortie de l'amplificateur opérationnel (30) dans le premier état de connexion et du signal de sortie de l'amplificateur opérationnel (30) dans le second état de connexion.

4. Dispositif capteur, comprenant :

un circuit en pont (10) comprenant des éléments capteurs dont l'impédance varie en fonction des variations d'une grandeur physique d'une cible de détection, une tension en un premier point milieu de pont (N1) et une tension en un second point milieu de pont (N2) présentant des variations, dont la quantité de variation est égale et la polarité est opposée, par rapport à une tension intermédiaire prédéterminée, en fonction des variations de l'impédance de l'élément capteur ;
un premier amplificateur opérationnel (31) comportant une borne d'entrée non inverseuse connectée au premier point milieu de pont (N1) et une borne d'entrée inverseuse connectée au second point milieu de pont (N2) ;
une première résistance de rétroaction (Rf1) disposée entre une borne de sortie et la borne d'entrée inverseuse du premier amplificateur opérationnel (31) ;
un second amplificateur opérationnel (32) comportant une borne d'entrée non inverseuse connectée au second point milieu de pont (N2) et une borne d'entrée inverseuse connectée au premier point milieu de pont (N1) ;
une seconde résistance de rétroaction (Rf2) disposée entre une borne de sortie et la borne d'entrée inverseuse du second amplificateur opérationnel (32) ;
une unité d'acquisition de signal de détection (51) qui acquiert un signal de détection indiquant un résultat de détection de la grandeur physique sur la base d'une différence entre un signal de sortie du premier amplificateur opérationnel (31) et un signal de sortie du second amplificateur opérationnel (32) ; et
une unité de détermination (52) qui détermine une anomalie du signal de détection sur la base d'une somme du signal de sortie du premier amplificateur opérationnel (31) et du signal de sortie du second amplificateur opérationnel (32).

5. Dispositif capteur selon l'une quelconque des revendications 1 à 4,
dans lequel le circuit en pont (10) comprend :

un premier élément capteur (R1) disposé entre une ligne d'alimentation en tension destinée à fournir une tension prédéterminée et le premier point milieu de pont(N1);
un deuxième élément capteur (R2) disposé entre le premier point milieu de pont (N1) et un potentiel de référence ;
un troisième élément capteur (R3) disposé entre la ligne d'alimentation en tension et le second point milieu de pont (N2) ; et
un quatrième élément capteur (R4) disposé entre le second point milieu de pont (N2) et le potentiel de référence.

FIG. 1

EP 3 130 894 B1

FIG. 2

EP 3 130 894 B1

FIG. 3

FIG. 4

EP 3 130 894 B1

**EP 3 130 894 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005049097 A

- US 3976987 A